# EUROPEAN PATENT APPLICATION

(11) **EP 4 383 314 A1**
(43) Date of publication of application: **12.06.2024**
(21) Application number: 22837606.7
(22) Date of filing: 30.06.2022
(51) Int. Cl.: H01L 21/3065

(54) **METHOD FOR CLEANING CHAMBER OR COMPONENT, SUBSTRATE PROCESSING METHOD AND SUBSTRATE PROCESSING APPARATUS**

(30) Priority: 05.07.2021 JP 2021111622
(71) Applicant: Tokyo Electron Limited, Tokyo 107-6325 (JP)
(72) Inventor: NAKANE, Yuta, Kurokawa-gun, Miyagi 981-3629 (JP); KUMAKURA, Sho, Kurokawa-gun, Miyagi 981-3629 (JP)
(74) Representative: Piotrowicz, Pawel Jan Andrzej
(86) International application number: PCT/JP2022/026362
(87) International publication number: WO 2023/282190

(57) **Abstract**

In one exemplary embodiment, a method for cleaning a chamber of a substrate processing apparatus or a component disposed in the chamber includes: (a) forming a second metal-containing substance from a first metal-containing substance adhering to the chamber or the component by using a first processing gas including a fluorine-containing gas in the chamber; and (b) removing the second metal-containing substance by using a second processing gas including a precursor in the chamber.

## Description

### Technical Field

Exemplary embodiments of the present disclosure relate to a method for cleaning a chamber or a component, a substrate processing method, and a substrate processing apparatus.

### Background Art

Patent Literature 1 discloses a method in which after etching of a laminated film of an aluminum film and a titanium nitride film, a mixed gas of boron trichloride and chlorine is converted into plasma and cleaning is performed.

### Citation List

### Patent Literature

[Patent Literature 1] Japanese Unexamined Patent Publication No. 2000-12515

### Summary of Invention

### Technical Problem

The present disclosure provides a cleaning method capable of suppressing damage to a chamber or a component, a substrate processing method, and a substrate processing apparatus.

### Solution to Problem

In one exemplary embodiment, there is provided a method for cleaning a chamber of a substrate processing apparatus or a component disposed in the chamber. The method includes (a) forming a second metal-containing substance from a first metal-containing substance adhering to the chamber or the component by using a first processing gas including a fluorine-containing gas in the chamber and (b) removing the second metal-containing substance by using a second processing gas including a precursor in the chamber.

### Advantageous Effects of Invention

According to one exemplary embodiment, a cleaning method capable of suppressing damage to a chamber or a component, a substrate processing method, and a substrate processing apparatus are provided.

### Brief Description of Drawings

FIG. 1 is a diagram schematically showing a substrate processing apparatus according to one exemplary embodiment.
FIG. 2 is a diagram schematically showing the substrate processing apparatus according to one exemplary embodiment.
FIG. 3 is a diagram schematically showing a substrate processing apparatus according to another exemplary embodiment.
FIG. 4 is a diagram schematically showing a substrate processing apparatus according to a further exemplary embodiment.
FIG. 5 is a partially enlarged sectional view of an exemplary substrate.
FIG. 6 is a flowchart of a cleaning method according to one exemplary embodiment.
FIG. 7 is a partially enlarged sectional view of an exemplary substrate processing apparatus in etching a substrate.
FIG. 8 is a partially enlarged sectional view of the exemplary substrate processing apparatus in forming a second metal-containing substance.
FIG. 9 is a partially enlarged sectional view of the exemplary substrate processing apparatus in removing the second metal-containing substance.
FIG. 10 is a partially enlarged sectional view of the exemplary substrate processing apparatus in exposing a chamber or a component to plasma generated from a third processing gas.

### Description of Embodiments

Hereinafter, various exemplary embodiments will be described.

In one exemplary embodiment, a method for cleaning a chamber of a substrate processing apparatus or a component disposed in the chamber includes: (a) forming a second metal-containing substance from a first metal-containing substance adhering to the chamber or the component by using a first processing gas including a fluorine-containing gas in the chamber; and (b) removing the second metal-containing substance by using a second processing gas including a precursor in the chamber.

In the method of the embodiment, the second metal-containing substance is formed by a reaction between the fluorine-containing gas and the first metal-containing substance in (a). In addition, the second metal-containing substance is removed by a reaction between the precursor and the second metal-containing substance in (b). According to the method of the embodiment, damage to the chamber or the component due to cleaning can be suppressed compared with a case where a metal-containing substance adhering to the chamber or the component is removed using a chlorine gas.

The method may further include (c) exposing the chamber or the component to a third processing gas or plasma generated from the third processing gas after (b). In this case, it is possible to remove residue present on the chamber or the component after removing the second metal-containing substance.

The method may further include (d) etching a substrate disposed in the chamber before (a). In this case, the chamber can be cleaned after etching of the substrate.

A first pressure in the chamber in (d) may be smaller than at least one of a second pressure in the chamber in (a) and a third pressure in the chamber in (b). In this case, since the second pressure or the third pressure during cleaning is larger than the first pressure during etching, the amount of the fluorine-containing gas or the precursor supplied during cleaning can be increased. Therefore, it is possible to increase a cleaning speed.

The substrate may include a metal-containing film. In this case, even in a case where the first metal-containing substance adheres to the chamber or the component by etching of the substrate, it is possible to remove the first metal-containing substance.

The method may further include (e) repeating (a) and (b) after (b). In this case, a larger amount of the first metal-containing substance can be removed.

In (a), the first processing gas may be used without generating plasma. In this case, the first processing gas can reach a wider region in the chamber than in a case of generating the plasma.

In (a), plasma generated from the first processing gas may be used.

In at least one of (a) and (b), the chamber or the component may be heated. In this case, the reaction between the first metal-containing substance and the fluorine-containing gas or the reaction between the second metal-containing substance and the precursor is accelerated.

The precursor may include a metal-containing precursor. In this case, the metal-containing precursor can react with the second metal-containing substance with low energy.

The metal-containing precursor may include a metal complex. In this case, another highly volatile metal complex is generated by a ligand exchange reaction between the second metal-containing substance and the metal complex.

The precursor may include a metal-free precursor. In this case, metal residue due to the reaction between the second metal-containing substance and the precursor is hardly generated.

In one exemplary embodiment, a substrate processing apparatus includes a chamber, a substrate support for supporting a substrate in the chamber, a gas supply configured to supply each of a first processing gas including a hydrogen fluoride gas and a second processing gas including a precursor into the chamber, and a controller, the controller is configured to control the gas supply in order to form a second metal-containing substance from a first metal-containing substance adhering to the chamber or a component disposed in the chamber by using the first processing gas in the chamber, and the controller is configured to control the gas supply in order to remove the second metal-containing substance by using the second processing gas in the chamber.

According to the substrate processing apparatus of the embodiment, damage to the chamber or the component due to cleaning can be suppressed compared with a case where a metal-containing substance adhering to the chamber or the component is removed using a chlorine gas.

The substrate processing apparatus may further include a heating device for heating the chamber or the component. In this case, the reaction between the first metal-containing substance and the fluorine-containing gas or the reaction between the second metal-containing substance and the precursor is accelerated by heating.

Hereinafter, various exemplary embodiments will be described in detail with reference to the drawings. In the drawings, the same or corresponding parts are denoted by the same references.

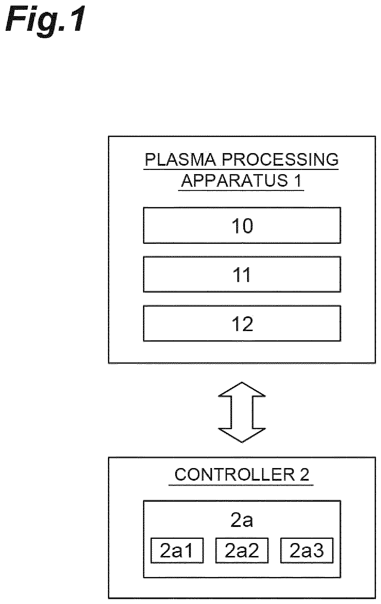

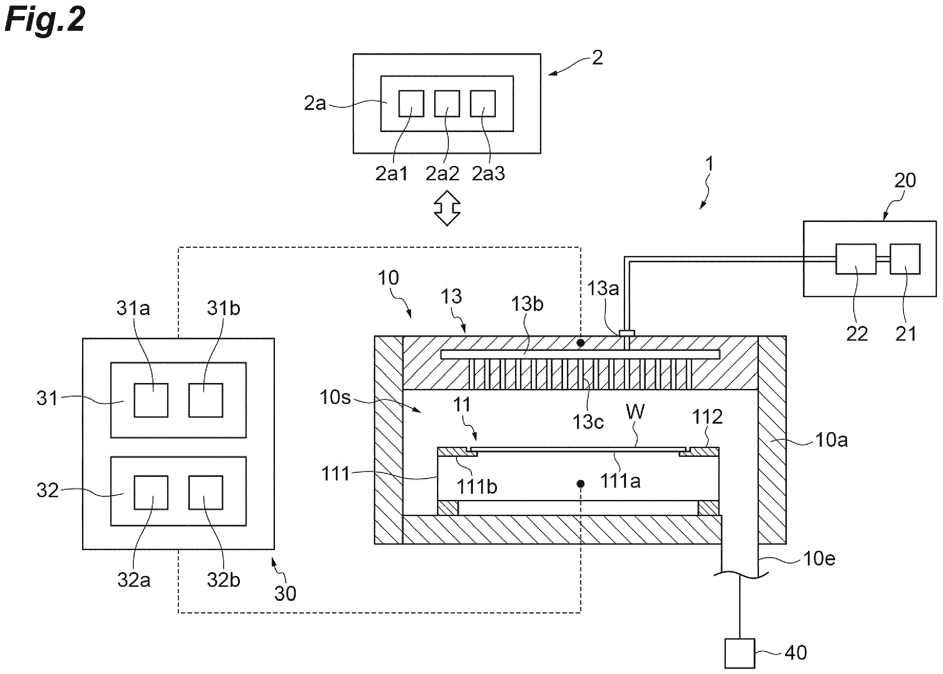

FIGS. 1 and 2 are diagrams schematically showing the substrate processing apparatus according to one exemplary embodiment. The substrate processing apparatus of the present embodiment is, for example, a plasma processing system.

In one embodiment, the plasma processing system includes a plasma processing apparatus 1 and a controller 2. The plasma processing apparatus 1 includes a plasma processing chamber 10, a substrate support 11, and a plasma generator 12. The plasma processing chamber 10 has a plasma processing space. In addition, the plasma processing chamber 10 has at least one gas supply port for supplying at least one processing gas to the plasma processing space and at least one gas discharge port for discharging the gas from the plasma processing space. The gas supply port is connected to a gas supply 20 to be described later, and the gas discharge port is connected to an exhaust system 40 to be described later. The substrate support 11 is disposed in the plasma processing space and has a substrate support surface for supporting the substrate.

The plasma generator 12 is configured to generate plasma from at least one processing gas supplied into the plasma processing space. The plasma formed in the plasma processing space may be capacitively coupled plasma (CCP), inductively coupled plasma (ICP), electron-cyclotron-resonance plasma (ECR plasma), helicon wave plasma (HWP), or surface wave plasma (SWP). In addition, various types of plasma generators may be used, including an alternating current (AC) plasma generator and a direct current (DC) plasma generator. In one embodiment, the AC signal (AC power) used in the AC plasma generator has a frequency in a range of 100 kHz to 10 GHz. Therefore, the AC signal includes a radio frequency (RF) signal and a microwave signal. In one embodiment, the RF signal has a frequency in a range of 200 kHz to 150 MHz.

The controller 2 processes computer-executable instructions that cause the plasma processing apparatus 1 to execute the various steps described in the present disclosure. The controller 2 may be configured to control each element of the plasma processing apparatus 1 to execute the various steps described herein. In one embodiment, a part or the whole of the controller 2 may be included in the plasma processing apparatus 1. The controller 2 may include, for example, a computer 2a. The computer 2a may include, for example, a central processing unit (CPU) 2a1, a storage unit 2a2, and a communication interface 2a3. The processing unit 2a1 may be configured to perform various control operations based on the program stored in the storage unit 2a2. The storage unit 2a2 may include a random access memory (RAM), a read only memory (ROM), a hard disk drive (HDD), a solid state drive (SSD), or combinations thereof. The communication interface 2a3 may be communicated with the plasma processing apparatus 1 through a communication line such as a local area network (LAN).

Hereinafter, a configuration example of the plasma processing system will be described.

The plasma processing system includes a capacitively coupled plasma processing apparatus 1 and a controller 2. The capacitively coupled plasma processing apparatus 1 includes a plasma processing chamber 10, a gas supply 20, a power source 30, and an exhaust system 40. In addition, the plasma processing apparatus 1 includes a substrate support 11 and a gas introduction unit. The gas introduction unit is configured to introduce at least one processing gas into the plasma processing chamber 10. The gas introduction unit includes a shower head 13. The substrate support 11 is disposed in the plasma processing chamber 10. The shower head 13 is disposed above the substrate support 11. In one embodiment, the shower head 13 constitutes at least a part of a ceiling of the plasma processing chamber 10. The plasma processing chamber 10 has a plasma processing space 10s defined by the shower head 13, side walls 10a of the plasma processing chamber 10, and the substrate support 11. The plasma processing chamber 10 has at least one gas supply port for supplying at least one processing gas to the plasma processing space 10s and at least one gas discharge port for discharging the gas from the plasma processing space. The side wall 10a is grounded. The shower head 13 and the substrate support 11 are electrically insulated from the housing of the plasma processing chamber 10.

The substrate support 11 includes a main body 111 and a ring assembly 112. The main body 111 has a central region (substrate support surface) 111a for supporting a substrate (wafer) W and an annular region (ring support surface) 111b for supporting the ring assembly 112. The annular region 111b of the main body 111 surrounds the central region 111a of the main body 111 in a plan view. The substrate W is disposed on the central region 111a of the main body 111, and the ring assembly 112 is disposed on the annular region 111b of the main body 111 to surround the substrate W on the central region 111a of the main body 111. In one embodiment, the main body 111 includes a base and an electrostatic chuck. The base includes a conductive member. The conductive member of the base functions as a lower electrode. The electrostatic chuck is disposed on the base. The upper surface of the electrostatic chuck has the substrate support surface 111a. The ring assembly 112 includes one or more annular members. At least one of the one or more annular members is an edge ring. In addition, although now shown in the drawing, the substrate support 11 may include a temperature adjusting module configured to adjust at least one of the electrostatic chuck, the ring assembly 112, and the substrate to a target temperature. The temperature adjusting module may include a heater, a heat transfer medium, a flow passage, or combinations thereof. A heat transfer fluid such as brine or gas flows through the flow passage. In addition, the substrate support 11 may include a heat transfer gas supply configured to supply a heat transfer gas to a gap between a rear surface of the substrate W and the substrate support surface 111a.

The shower head 13 is configured to introduce at least one processing gas from the gas supply 20 into the plasma processing space 10s. The shower head 13 has at least one gas supply port 13a, at least one gas diffusion chamber 13b, and a plurality of gas introduction ports 13c. The processing gas supplied to the gas supply port 13a passes through the gas diffusion chamber 13b and is introduced into the plasma processing space 10s from the plurality of gas introduction ports 13c. In addition, the shower head 13 includes a conductive member. The conductive member of the shower head 13 functions as an upper electrode. The gas introduction unit may include one or more side gas injectors (SGI) attached to one or more openings formed in the side wall 10a, in addition to the shower head 13.

The gas supply 20 may include at least one gas source 21 and at least one flow rate controller 22. In one embodiment, the gas supply 20 is configured to supply at least one processing gas from each corresponding gas source 21 to the shower head 13 through each corresponding flow rate controller 22. Each flow rate controller 22 may include, for example, a mass flow controller or a pressure control type flow rate controller. Furthermore, the gas supply 20 may include one or more flow rate modulation devices that modulate or pulse the flow rate of at least one processing gas.

The power source 30 includes an RF power source 31 coupled to the plasma processing chamber 10 through at least one impedance matching circuit. The RF power source 31 is configured to supply at least one RF signal (RF power) such as a source RF signal and a bias RF signal to the conductive member of the substrate support 11 and/or the conductive member of the shower head 13. Accordingly, plasma is formed from at least one processing gas supplied to the plasma processing space 10s. Therefore, the RF power source 31 may function as at least a part of a plasma generator configured to generate plasma from the one or more processing gases in the plasma processing chamber 10. Further, by supplying a bias RF signal to the conductive member of the substrate support 11, a bias potential is generated in the substrate W and ion components in the formed plasma can be drawn to the substrate W.

In one embodiment, the RF power source 31 includes a first RF generator 31a and a second RF generator 31b. The first RF generator 31a is configured to be coupled to the conductive member of the substrate support 11 and/or the conductive member of the shower head 13 through at least one impedance matching circuit and to generate a source RF signal (source RF power) for plasma generation. In one embodiment, the source RF signal has a frequency in a range of 13 MHz to 150 MHz. In one embodiment, the first RF generator 31a may be configured to generate a plurality of source RF signals having different frequencies. The generated one or more source RF signals are supplied to the conductive member of the substrate support 11 and/or the conductive member of the shower head 13. The second RF generator 31b is configured to be coupled to the conductive member of the substrate support 11 through at least one impedance matching circuit and to generate a bias RF signal (bias RF power). In one embodiment, the bias RF signal has a lower frequency than the source RF signal. In one embodiment, the bias RF signal has a frequency in a range of 400 kHz to 13.56 MHz. In one embodiment, the second RF generator 31b may be configured to generate a plurality of bias RF signals having different frequencies. The generated one or more bias RF signals are supplied to the conductive member of the substrate support 11. Further, in various embodiments, at least one of the source RF signal and the bias RF signal may be pulsed.

In addition, the power source 30 may include a DC power source 32 coupled to the plasma processing chamber 10. The DC power source 32 includes a first DC generator 32a and a second DC generator 32b. In one embodiment, the first DC generator 32a is configured to be connected to the conductive member of the substrate support 11 and to generate a first DC signal. The generated first bias DC signal is applied to the conductive member of the substrate support 11. In one embodiment, the first DC signal may be applied to another electrode such as an electrode in the electrostatic chuck. In one embodiment, the second DC generator 32b is connected to the conductive member of the shower head 13 and is configured to generate a second DC signal. The generated second DC signal is applied to the conductive member of the shower head 13. In various embodiments, at least one of the first and second DC signals may be pulsed. The first and second DC generators 32a and 32b may be provided in addition to the RF power source 31, or the first DC generator 32a may be provided in place of the second RF generator 31b.

The exhaust system 40 may be connected to, for example, a gas discharge port 10e provided in a bottom portion of the plasma processing chamber 10. The exhaust system 40 may include a pressure adjusting valve and a vacuum pump. The pressure in the plasma processing space 10s is adjusted by the pressure adjusting valve. The vacuum pump may include a turbo molecular pump, a dry pump, or combinations thereof.

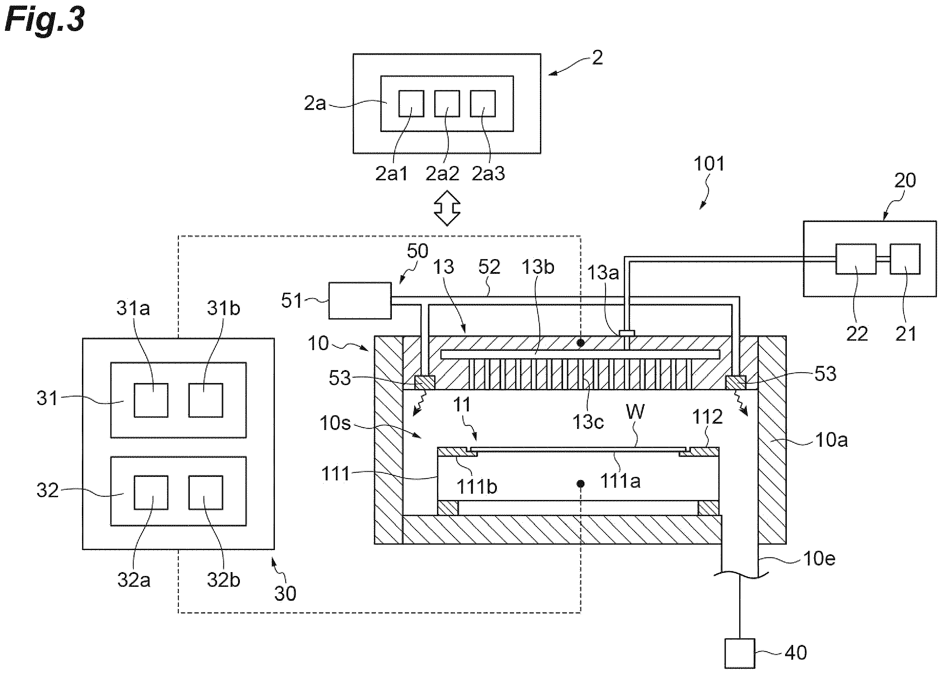

FIG. 3 is a diagram schematically showing a substrate processing apparatus according to another exemplary embodiment. A plasma processing apparatus 101 shown in FIG. 3 further includes a heating device 50 in addition to the configuration of the plasma processing apparatus 1 shown in FIG. 2. The heating device 50 can heat a plasma processing chamber 10 or a component (for example, a substrate support 11) disposed in the plasma processing chamber 10.

The heating device 50 may include a microwave generator 51, a waveguide 52, and a quartz window 53. The microwave generator 51 is provided outside the plasma processing chamber 10, for example, above a shower head 13. The microwave generator 51 includes a magnetron and generates a microwave. The frequency of the microwave is, for example, 2.45 GHz or 5.85 GHz. One end of the waveguide 52 is connected to the microwave generator 51. The other end of the waveguide 52 is connected to the quartz window 53. The quartz window 53 is provided in the shower head 13. The microwave generated in the microwave generator 51 is irradiated toward the plasma processing chamber 10 or the substrate support 11 through the waveguide 52 and the quartz window 53. Accordingly, the inner surface of the plasma processing chamber 10 or the surface of the substrate support 11 is heated. The irradiation direction of the microwave can be adjusted by the positions or directions of the waveguide 52 and the quartz window 53.

The heating device 50 may heat the plasma processing chamber 10 or the substrate support 11 by generating an electromagnetic wave (for example, an infrared ray) different from the microwave. The heating device 50 may be provided with an infrared lamp.

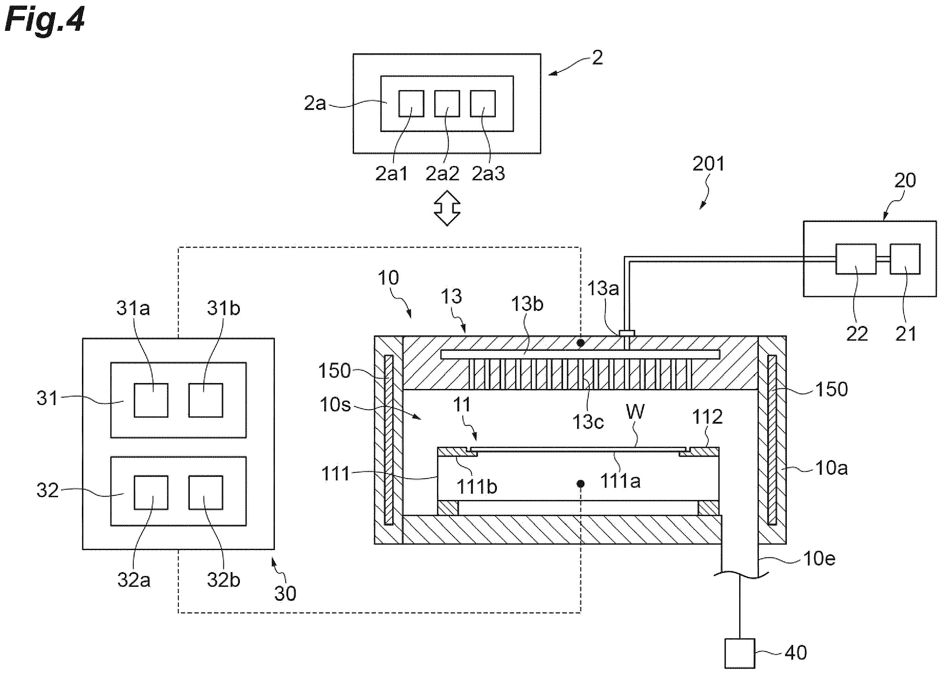

FIG. 4 is a diagram schematically showing a substrate processing apparatus according to a further exemplary embodiment. A plasma processing apparatus 201 shown in FIG. 4 further includes a heating device 150 in addition to the configuration of the plasma processing apparatus 1 shown in FIG. 2. The heating device 150 can heat a plasma processing chamber 10. The heating device 150 may be a temperature adjusting module embedded in a side wall 10a of the plasma processing chamber 10. The temperature adjusting module may be embedded in a part of the plasma processing chamber 10 different from the side wall 10a. A substrate support 11 may be heated by the temperature adjusting module embedded in the substrate support 11. The temperature adjusting module may include a heater, a heat transfer medium, a flow passage, or combinations thereof.

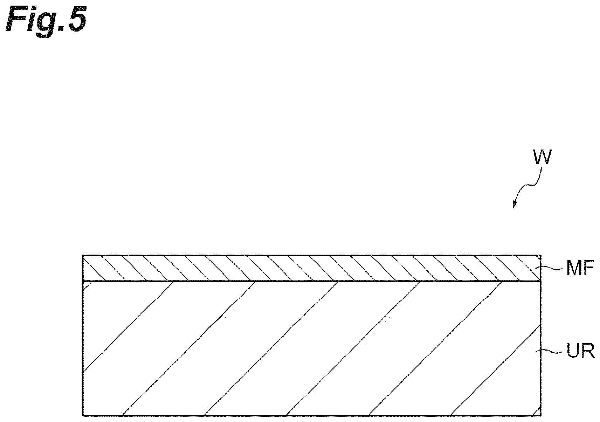

FIG. 5 is a partially enlarged sectional view of an exemplary substrate. As shown in FIG. 5, in one embodiment, the substrate W includes a base region UR and a metal-containing film MF. The metal-containing film MF is provided on the base region UR. The base region UR may be a base film. The base region UR may contain silicon.

The metal-containing film MF may contain at least one of oxygen and nitrogen. The metal-containing film MF may contain at least one of a metal oxide and a metal nitride. The metal-containing film MF may contain at least one of Al, Hf, Zr, Fe, Ni, Co, Mn, Mg, Rh, Ru, Cr, Si, Ti, Ga, In, Zn, Pb, Ge, Ta, Cu, W, Mo, Pt, Cd, and Sn.

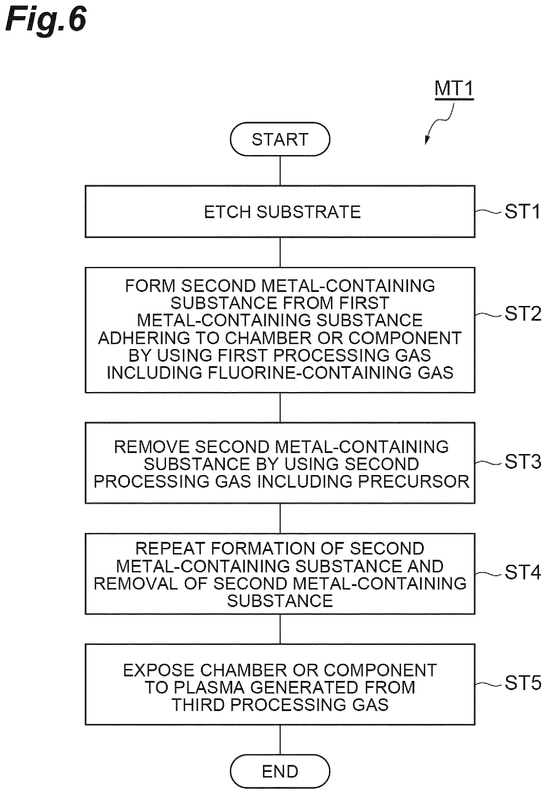

FIG. 6 is a flowchart of a cleaning method according to one exemplary embodiment. The cleaning method shown in FIG. 6 (hereinafter, referred to as "method MT1") may be executed by the substrate processing apparatus of each of the above-described embodiments. The method MT1 may be a substrate processing method using the substrate processing apparatus of each of the above-described embodiments. The method MT1 may include Steps ST1 to ST5. Steps ST1 to ST5 may be executed in order. Steps ST1, ST4, and ST5 may not be executed.

Hereinafter, the method MT1 will be described with reference to FIGS. 6 to 10. In a case where the plasma processing apparatus 1, 101, or 201 is used, the method MT1 may be executed in the plasma processing apparatus 1, 101, or 201 under the control of each part of the plasma processing apparatus 1, 101, or 201 by the controller 2. In the method MT1, it is possible to clean the plasma processing chamber 10 or a component (for example, the substrate support 11) disposed in the plasma processing chamber 10. Hereinafter, an example in which the plasma processing chamber 10 or the substrate support 11 is cleaned will be described. Steps ST2 to ST5 of the method MT1 may be performed in a state in which a substrate W1 for cleaning (dummy wafer) is disposed instead of the substrate W on the substrate support 11. Accordingly, damage to the substrate support 11 due to cleaning can be suppressed. Step ST1 may be performed in a state in which the substrate W is disposed on the substrate support 11. After Step ST1, the substrate W may be transferred out of the plasma processing chamber 10. After that, the substrate W1 for cleaning may be transferred into the plasma processing chamber 10. After that, Step ST3 may be performed.

### (Step ST1)

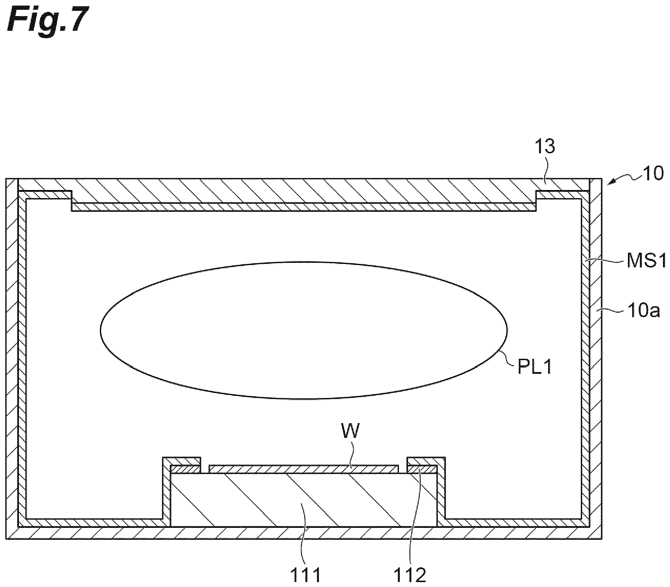

FIG. 7 is a partially enlarged sectional view of an exemplary substrate processing apparatus in etching a substrate. In Step ST1, the substrate W disposed in the plasma processing chamber 10 is etched. The substrate W may be etched using plasma PL1. The plasma PL1 may be generated from a processing gas supplied from the gas supply 20 into the plasma processing chamber 10 by the plasma generator 12. The pressure in the plasma processing chamber 10 may be set to a first pressure P1 by the exhaust system 40.

After the end of Step ST1, a first metal-containing substance MS1 may adhere to the plasma processing chamber 10 or the substrate support 11 by etching. The first metal-containing substance MS1 may cover the inner surface of the plasma processing chamber 10 and the surface of the substrate support 11. The first metal-containing substance MS1 may contain the same metal as the metal contained in the metal-containing film MF. The first metal-containing substance MS1 may contain at least one of Al, Hf, Zr, Fe, Ni, Co, Mn, Mg, Rh, Ru, Cr, Si, Ti, Ga, In, Zn, Pb, Ge, Ta, Cu, W, Mo, Pt, Cd, and Sn. The first metal-containing substance MS1 may contain at least one of oxygen and nitrogen. The first metal-containing substance MS1 may contain at least one of a metal oxide and a metal nitride.

### (Step ST2)

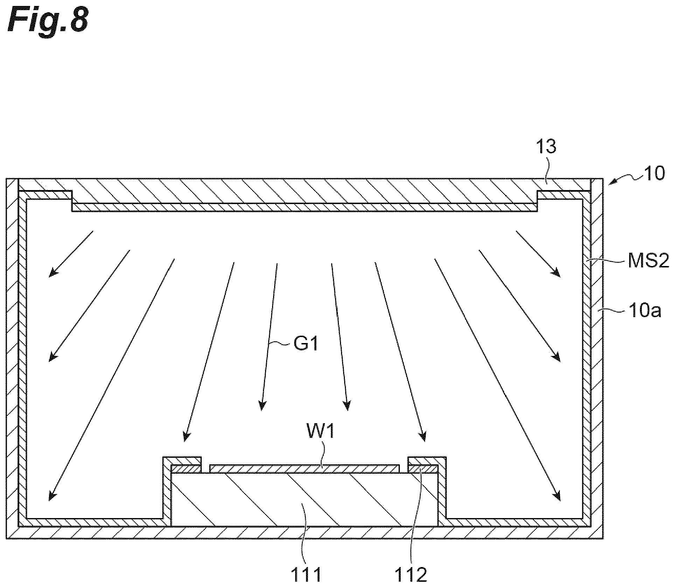

FIG. 8 is a partially enlarged sectional view of the exemplary substrate processing apparatus in forming a second metal-containing substance. In Step ST2, in the plasma processing chamber 10, a second metal-containing substance MS2 is formed from the first metal-containing substance MS1 adhering to the plasma processing chamber 10 or the substrate support 11 by using a first processing gas G1 including a fluorine-containing gas. The second metal-containing substance MS2 may cover the inner surface of the plasma processing chamber 10 and the surface of the substrate support 11. The first processing gas G1 is supplied from the gas supply 20 into the plasma processing chamber 10.

The fluorine-containing gas may include at least one of a hydrogen fluoride gas (HF gas), a fluorocarbon gas, a nitrogen-containing gas, and a sulfur-containing gas. The fluorocarbon gas may include at least one of a C₄F₆ gas, a C₄F₈ gas, a C₃F₈ gas, and a CF₄ gas. The nitrogen-containing gas may include an NF₃ gas. The sulfur-containing gas may include an SF₆ gas.

The second metal-containing substance MS2 may be generated by the reaction between the first metal-containing substance MS1 and the fluorine-containing gas. The second metal-containing substance MS2 may contain the same metal as the metal contained in the first metal-containing substance MS1 and fluorine. The second metal-containing substance MS2 is, for example, a metal fluoride. In one example, the first metal-containing substance MS1 includes an aluminum oxide and the fluorine-containing gas includes a hydrogen fluoride gas. In this case, the second metal-containing substance MS2 includes an aluminum fluoride.

In Step ST2, the first processing gas G1 may be used without generating plasma, or plasma generated from the first processing gas G1 may be used. In a case where no plasma is generated, the first processing gas G1 may include a hydrogen fluoride gas.

In Step ST2, the pressure in the plasma processing chamber 10 may be set to a second pressure P2 by the exhaust system 40. The second pressure P2 is larger than the first pressure P1 in Step ST1. The second pressure P2 may be 100 mTorr (13 Pa) or greater.

In Step ST2, the plasma processing chamber 10 or the substrate support 11 may be heated. The temperature of the plasma processing chamber 10 or the substrate support 11 may be 100°C or higher, 150°C or higher, or 200°C or higher. The temperature of the plasma processing chamber 10 or the substrate support 11 may be 450°C or lower. The heating may be performed by plasma generated in the plasma processing chamber 10 or by the heating device 50 or 150. The heating accelerates the reaction between the first metal-containing substance MS1 and the fluorine-containing gas.

After Step ST2, a purge step may be performed. In the purge step, a purge gas is supplied into the plasma processing chamber 10, and then exhausted. The purge gas is, for example, an inert gas such as nitrogen or argon.

### (Step ST3)

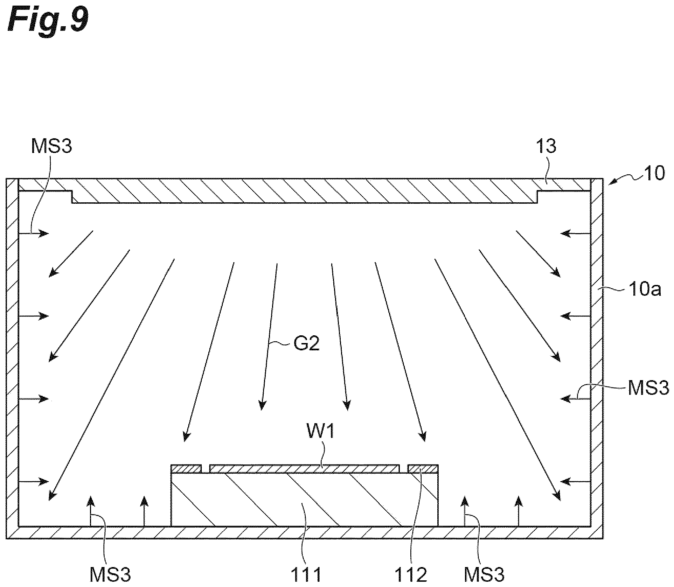

FIG. 9 is a partially enlarged sectional view of the exemplary substrate processing apparatus in removing the second metal-containing substance. In Step ST3, in the plasma processing chamber 10, the second metal-containing substance MS2 is removed by using a second processing gas G2 including a precursor. The second processing gas G2 is supplied from the gas supply 20 into the plasma processing chamber 10. In Step ST3, the second processing gas G2 may be used without generating plasma.

The precursor may include a metal-containing precursor. The metal-containing precursor may include a metal complex. The metal complex may be a complex including a monodentate ligand or a chelate. The monodentate ligand may be at least one of an alkyl, a hydride, a carbonyl, a halide, an alkoxide, an alkylamide, and a silylamide. The chelate may be at least one of β-diketonate, amidinate, acetamidinate, β-diketiminate, diaminoalkoxide, and metallocene. The β-diketonate may be at least one of acetylacetonate (acac), hexafluoroacetylacetonate (fac), trifluoroacetylacetonate (tfac), and tetramethylheptanedionate (ttmhd).

The metal contained in the metal-containing precursor may be at least one of Sn, Ge, Al, B, Ga, In, Zn, Ni, Pb, Si, Hf, Zr, and Ti.

The precursor may include a metal-free precursor. The metal-free precursor may include a carbon-containing precursor. The carbon-containing precursor may be at least one of alcohol, β-diketone, amidine, acetamidine, and β-diketimine. The β-diketone may be at least one of acetylacetone (acac), hexafluoroacetylacetone (hfac), trifluoroacetylacetone (tfac), and tetramethylheptanedione (tmhd).

In Step ST3, a volatile third metal-containing substance MS3 may be generated by the reaction between the second metal-containing substance MS2 and the precursor. Accordingly, the second metal-containing substance MS2 is removed. In a case where the precursor includes a metal-containing precursor, the metal-containing precursor can react with the second metal-containing substance with low energy. In a case where the metal-containing precursor includes a metal complex, due to a ligand exchange reaction between the second metal-containing substance MS2 and the metal complex, another highly volatile metal complex is generated. In one example, the second metal-containing substance MS2 includes an aluminum fluoride, and the metal-containing precursor includes tin (II) acetylacetonate (Sn(acac)₂). In a case where the precursor includes a metal-free precursor, metal residue due to the reaction between the second metal-containing substance and the precursor is hardly generated. In a case where the metal-free precursor includes a carbon-containing precursor, residue containing a carbon compound is generated. The residue containing a carbon compound may be relatively easily removed.

In Step ST3, the pressure in the plasma processing chamber 10 may be set to a third pressure P3 by the exhaust system 40. The third pressure P3 is larger than the first pressure P1 in Step ST1. The third pressure P3 may be the same as or different from the second pressure P2 in Step ST2.

Similarly to Step ST2, the plasma processing chamber 10 or the substrate support 11 may be heated in Step ST3. The heating accelerates the reaction between the second metal-containing substance MS2 and the precursor.

After Step ST3, a purge step may be performed in the same manner as the purge step that is performed after Step ST2.

### (Step ST4)

In Step ST4, Steps ST2 and ST3 are repeated. Steps ST2 and ST3 may be repeated a plurality of times. A larger amount of the first metal-containing substance MS1 can be removed through Step ST4. Steps ST2 and ST3 are alternately performed. A purge step may be performed between Steps ST2 and ST3.

### (Step ST5)

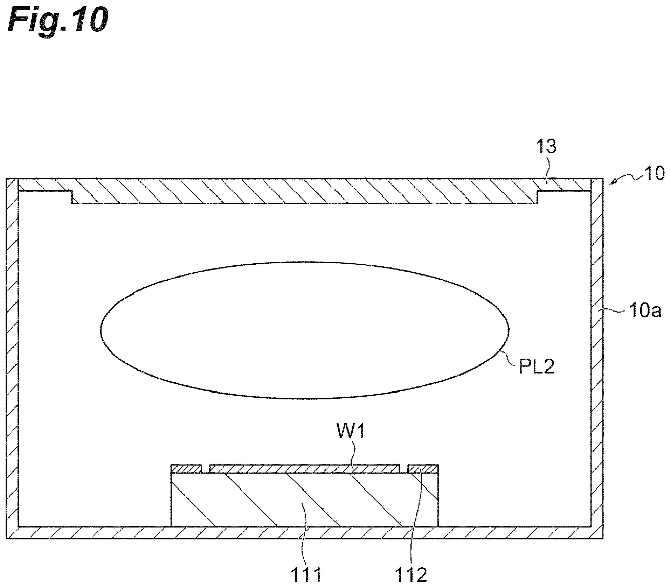

FIG. 10 is a partially enlarged sectional view of the exemplary substrate processing apparatus in exposing the chamber or the component to plasma generated from a third processing gas. In Step ST5, the plasma processing chamber 10 or the substrate support 11 is exposed to plasma PL2 generated from the third processing gas. The plasma PL2 may be generated by the plasma generator 12 from the third processing gas supplied from the gas supply 20 into the plasma processing chamber 10. The plasma processing chamber 10 or the substrate support 11 may be exposed to the third processing gas without generating plasma.

The third processing gas may include at least one of a fluorine-containing gas, an oxygen-containing gas, a hydrogen-containing gas, and a nitrogen-containing gas. The fluorine-containing gas may include at least one of a fluorocarbon gas, a nitrogen-containing gas, and a sulfur-containing gas. The fluorocarbon gas may include at least one of a C₄F₆ gas, a C₄F₈ gas, a C₃F₈ gas, and a CF₄ gas. The nitrogen-containing gas may include an NF₃ gas. The sulfur-containing gas may include an SF₆ gas. The oxygen-containing gas may include at least one of an oxygen gas, a carbon monoxide gas, and a carbon dioxide gas. The hydrogen-containing gas may include a hydrogen gas. The nitrogen-containing gas may include a nitrogen gas. In a case where the precursor included in the second processing gas G2 contains Sn, the third processing gas may include at least one of a hydrogen gas, a CH₄ gas, and a carbon monoxide gas. In a case where the precursor included in the second processing gas G2 contains Si, Ge, or B, the third processing gas may include a fluorine-containing gas. In a case where the precursor included in the second processing gas G2 contains Pb, Ni, Al, Zn, Hf, or Zr, the third processing gas may include at least one of a CH₄ gas and a carbon monoxide gas. In a case where the precursor included in the second processing gas G2 includes a metal-free precursor, the third processing gas may include at least one of a hydrogen gas and an oxygen gas.

Through Step ST5, it is possible to remove the residue (for example, the first metal-containing substance MS1, the second metal-containing substance MS2, or other metal-containing substances) present on the plasma processing chamber 10 or the substrate support 11 after removal of the second metal-containing substance MS2.

According to the method MT1 described above, damage to the plasma processing chamber 10 or the substrate support 11 due to cleaning can be suppressed compared with a case where a chlorine gas is used.

In a case where the first pressure P1 in Step ST1 is smaller than the second pressure P2 in Step ST2 or the third pressure P3 in Step ST3, the amount of the fluorine-containing gas or the precursor supplied during cleaning can be increased. Therefore, it is possible to increase a cleaning speed.

In a case where the first processing gas G1 is used without generating plasma in Step ST2, the first processing gas G1 can reach a wider region in the plasma processing space 10s in the plasma processing chamber 10 than in a case of generating the plasma. Furthermore, damage to the plasma processing chamber 10 or the substrate support 11 due to plasma can be suppressed.

Although the various exemplary embodiments have been described above, various additions, omissions, substitutions, and changes may be made without being limited to the exemplary embodiments described above. In addition, elements in different embodiments can be combined to form other embodiments.

For example, the substrate processing apparatus may not include the plasma generator 12. In this case, the plasma processing is not performed in the chamber of the substrate processing apparatus. The method MT1 can also be performed using such a substrate processing apparatus.

Here, the various exemplary embodiments included in the present disclosure are described in (Supplementary Note 1) to (Supplementary Note 20) below.

### (Supplementary Note 1)

A method for cleaning a chamber of a substrate processing apparatus or a component disposed in the chamber, the method including:
(a) forming a second metal-containing substance from a first metal-containing substance adhering to the chamber or the component by using a first processing gas including a fluorine-containing gas in the chamber; and
(b) removing the second metal-containing substance by using a second processing gas including a precursor in the chamber.

### (Supplementary Note 2)

The method according to Supplementary Note 1, further including (c) exposing the chamber or the component to a third processing gas or plasma generated from the third processing gas after (b).

### (Supplementary Note 3)

The method according to Supplementary Note 1 or 2, further including (d) etching a substrate disposed in the chamber before (a).

### (Supplementary Note 4)

The method according to Supplementary Note 3, in which a first pressure in the chamber in (d) is smaller than at least one of a second pressure in the chamber in (a) and a third pressure in the chamber in (b).

### (Supplementary Note 5)

The method according to Supplementary Note 3 or 4, in which the substrate includes a metal-containing film.

### (Supplementary Note 6)

The method according to any one of Supplementary Notes 1 to 5, further including (e) repeating (a) and (b) after (b).

### (Supplementary Note 7)

The method according to any one of Supplementary Notes 1 to 6, in which in (a), the first processing gas is used without generating plasma.

### (Supplementary Note 8)

The method according to any one of Supplementary Notes 1 to 6, in which in (a), plasma generated from the first processing gas is used.

### (Supplementary Note 9)

The method according to any one of Supplementary Notes 1 to 8, in which in at least one of (a) and (b), the chamber or the component is heated.

### (Supplementary Note 10)

The method according to any one of Supplementary Notes 1 to 9, in which the precursor includes a metal-containing precursor.

### (Supplementary Note 11)

The method according to Supplementary Note 10, in which the metal-containing precursor includes a metal complex.

### (Supplementary Note 12)

The method according to Supplementary Note 11, in which the metal complex is a complex including at least one monodentate ligand selected from the group consisting of an alkyl, a hydride, a carbonyl, a halide, an alkoxide, an alkylamide, and a silylamide, or at least one chelate selected from the group consisting of β-diketonate, amidinate, acetamidinate, β-diketiminate, diaminoalkoxide, and metallocene.

### (Supplementary Note 13)

The method according to any one of Supplementary Notes 1 to 12, in which the precursor includes a metal-free precursor.

### (Supplementary Note 14)

The method according to Supplementary Note 13, in which the metal-free precursor is at least one β-diketone selected from the group consisting of acetylacetone (acac), hexafluoroacetylacetone (hfac), trifluoroacetylacetone (tfac), and tetramethylheptanedione (tmhd).

### (Supplementary Note 15)

A substrate processing method using a substrate processing apparatus including
a chamber, and
a gas supply configured to supply each of a first processing gas including a fluorine-containing gas and a second processing gas including a metal-containing precursor or a carbon-containing precursor into the chamber,
the method including:
   (a) etching a substrate including a base film and a metal-containing film on the base film in the chamber, in which a first metal-containing substance containing a metal contained in the metal-containing film adheres to the chamber or a component disposed in the chamber by the etching;
   (b) forming a second metal-containing substance from the first metal-containing substance by using the first processing gas in the chamber; and
   (c) removing the second metal-containing substance by using the second processing gas in the chamber,
in which the metal-containing film contains at least one selected from the group consisting of Al, Hf, Zr, Fe, Ni, Co, Mn, Mg, Rh, Ru, Cr, Si, T, Ga, In, Zn, Pb, Ge, Ta, Cu, W, Mo, Pt, Cd, and Sn,
the fluorine-containing gas includes at least one selected from the group consisting of a hydrogen fluoride gas, a fluorocarbon gas, a nitrogen-containing gas, and a sulfur-containing gas,
the metal-containing precursor is a complex including a monodentate ligand or a chelate, containing at least one metal selected from the group consisting of Sn, Ge, Al, B, Ga, In, Zn, Ni, Pb, Si, Hf, Zr, and Ti, and
the carbon-containing precursor is at least one selected from the group consisting of alcohol, β-diketone, amidine, acetamidine, and β-diketimine.

### (Supplementary Note 16)

A substrate processing apparatus including:
a chamber;
a substrate support for supporting a substrate in the chamber;
a gas supply configured to supply each of a first processing gas including a hydrogen fluoride gas and a second processing gas including a precursor into the chamber; and
a controller,
in which the controller is configured to control the gas supply in order to form a second metal-containing substance from a first metal-containing substance adhering to the chamber or a component disposed in the chamber by using the first processing gas in the chamber, and
the controller is configured to control the gas supply in order to remove the second metal-containing substance by using the second processing gas in the chamber.

### (Supplementary Note 17)

The substrate processing apparatus according to Supplementary Note 16, further including a heating device for heating the chamber or the component.

### (Supplementary Note 18)

The substrate processing apparatus according to Supplementary Note 17, in which the heating device is a device for heating the chamber or the component by an electromagnetic wave.

### (Supplementary Note 19)

The substrate processing apparatus according to Supplementary Note 18, in which the heating device includes a microwave generator.

### (Supplementary Note 20)

The substrate processing apparatus according to Supplementary Note 17, in which the heating device is a temperature adjusting module disposed in a side wall of the chamber or in the substrate support.

From the above description, it will be understood that various embodiments of the present disclosure have been described herein for purposes of description, and that various modifications may be made without departing from the scope and spirit of the present disclosure. Accordingly, the various embodiments disclosed herein are not intended to be limiting, with the true scope and spirit being indicated by the aspects following claims.

### Reference Signs List

2: controller
10: plasma processing chamber
11: substrate support
20: gas supply
G1: first processing gas
G2: second processing gas
MS 1: first metal-containing substance
MS2: second metal-containing substance
W: substrate

## Claims

1. A method for cleaning a chamber of a substrate processing apparatus or a component disposed in the chamber, the method comprising:
(a) forming a second metal-containing substance from a first metal-containing substance adhering to the chamber or the component by using a first processing gas including a fluorine-containing gas in the chamber; and
(b) removing the second metal-containing substance by using a second processing gas including a precursor in the chamber.

2. The method according to claim 1, further comprising (c) exposing the chamber or the component to a third processing gas or plasma generated from the third processing gas after (b).

3. The method according to claim 1 or 2, further comprising (d) etching a substrate disposed in the chamber before (a).

4. The method according to claim 3, wherein a first pressure in the chamber in (d) is smaller than at least one of a second pressure in the chamber in (a) and a third pressure in the chamber in (b).

5. The method according to claim 3 or 4, wherein the substrate includes a metal-containing film.

6. The method according to any one of claims 1 to 5, further comprising (e) repeating (a) and (b) after (b).

7. The method according to any one of claims 1 to 6, wherein in (a), the first processing gas is used without generating plasma.

8. The method according to any one of claims 1 to 6, wherein in (a), plasma generated from the first processing gas is used.

9. The method according to any one of claims 1 to 8, wherein in at least one of (a) and (b), the chamber or the component is heated.

10. The method according to any one of claims 1 to 9, wherein the precursor includes a metal-containing precursor.

11. The method according to claim 10, wherein the metal-containing precursor includes a metal complex.

12. The method according to claim 11, wherein the metal complex is a complex including at least one monodentate ligand selected from the group consisting of an alkyl, a hydride, a carbonyl, a halide, an alkoxide, an alkylamide, and a silylamide, or at least one chelate selected from the group consisting of β-diketonate, amidinate, acetamidinate, β-diketiminate, diaminoalkoxide, and metallocene.

13. The method according to any one of claims 1 to 12, wherein the precursor includes a metal-free precursor.

14. The method according to claim 13, wherein the metal-free precursor is at least one β-diketone selected from the group consisting of acetylacetone (acac), hexafluoroacetylacetone (hfac), trifluoroacetylacetone (tfac), and tetramethylheptanedione (tmhd).

15. A substrate processing method using a substrate processing apparatus including
a chamber, and
a gas supply configured to supply each of a first processing gas including a fluorine-containing gas and a second processing gas including a metal-containing precursor or a carbon-containing precursor into the chamber,
the method comprising:
(a) etching a substrate including a base film and a metal-containing film on the base film in the chamber, wherein a first metal-containing substance containing a metal contained in the metal-containing film adheres to the chamber or a component disposed in the chamber by the etching;
(b) forming a second metal-containing substance from the first metal-containing substance by using the first processing gas in the chamber; and
(c) removing the second metal-containing substance by using the second processing gas in the chamber,
wherein the metal-containing film contains at least one selected from the group consisting of Al, Hf, Zr, Fe, Ni, Co, Mn, Mg, Rh, Ru, Cr, Si, T, Ga, In, Zn, Pb, Ge, Ta, Cu, W, Mo, Pt, Cd, and Sn,
the fluorine-containing gas includes at least one selected from the group consisting of a hydrogen fluoride gas, a fluorocarbon gas, a nitrogen-containing gas, and a sulfur-containing gas,
the metal-containing precursor is a complex including a monodentate ligand or a chelate, containing at least one metal selected from the group consisting of Sn, Ge, Al, B, Ga, In, Zn, Ni, Pb, Si, Hf, Zr, and Ti, and
the carbon-containing precursor is at least one selected from the group consisting of alcohol, β-diketone, amidine, acetamidine, and β-diketimine.

16. A substrate processing apparatus comprising:
a chamber;
a substrate support for supporting a substrate in the chamber;
a gas supply configured to supply each of a first processing gas including a hydrogen fluoride gas and a second processing gas including a precursor into the chamber; and
a controller,
wherein the controller is configured to control the gas supply in order to form a second metal-containing substance from a first metal-containing substance adhering to the chamber or a component disposed in the chamber by using the first processing gas in the chamber, and
the controller is configured to control the gas supply in order to remove the second metal-containing substance by using the second processing gas in the chamber.

17. The substrate processing apparatus according to claim 16, further comprising a heating device for heating the chamber or the component.

18. The substrate processing apparatus according to claim 17, wherein the heating device is a device for heating the chamber or the component by an electromagnetic wave.

19. The substrate processing apparatus according to claim 18, wherein the heating device includes a microwave generator.

20. The substrate processing apparatus according to claim 17, wherein the heating device is a temperature adjusting module disposed in a side wall of the chamber or in the substrate support.
